# EUROPÄISCHE PATENTSCHRIFT

(11) **EP 3 483 677 B1**
(45) Veröffentlichungstag und Bekanntmachung des Hinweises auf die Patenterteilung: **16.10.2024**
(21) Anmeldenummer: 18204571.6
(22) Anmeldetag: 06.11.2018
(51) Int. Cl.: G05B 19/042, G06F 8/38

(54) **VERFAHREN ZUR EINBINDUNG VON ZUMINDEST EINER, EINE DATENSCHNITTSTELLE AUFWEISENDE ÜBERWACHUNGS- UND/ODER STEUERVORRICHTUNG EINES ÜBERWACHUNGS- UND/ODER AUTOMATISIERUNGSSYSTEMS IN EINE BENUTZERSCHNITTSTELLE**
METHOD FOR INTEGRATING AT LEAST ONE MONITORING AND/OR CONTROL DEVICE OF A MONITORING AND/OR AUTOMATION SYSTEM COMPRISING A DATA INTERFACE IN A USER INTERFACE
PROCÉDÉ D'INCORPORATION DANS UNE INTERFACE UTILISATEUR D'AU MOINS UN DISPOSITIF DE SURVEILLANCE ET / OU DE COMMANDE, COMPORTANT UNE INTERFACE DE DONNÉES, D'UN SYSTÈME DE SURVEILLANCE ET / OU D'AUTOMATISATION

(30) Priorität: 14.11.2017 AT 509522017
(43) Veröffentlichungstag der Anmeldung: 15.05.2019
(73) Patentinhaber: Leitner, Georg, 8010 Graz (AT)
(72) Erfinder: Leitner, Georg, 8010 Graz (AT)
(74) Vertreter: Röggla, Harald

(56) Entgegenhaltungen:
- EP-A1- 3 156 856
- US-A1- 2009 307 255
- US-A1- 2014 152 433
- US-A1- 2016 091 217
- US-A1- 2017 046 012
- ESQUIVEL ESTEBAN ARROYO: "Capturing and Exploiting Plant Topology and Process Information as a Basis to Support Engineering and Operational Activities in Process Plants", 9 June 2017 (2017-06-09), XP055959452, Retrieved from the Internet <URL:https://opus.ub.hsu-hh.de/volltexte/2017/3162/pdf/PhDDissertation_Arroyo_Final.pdf> [retrieved on 20220909]
- SANTOSH K C ET AL: "Graphical symbol recognition", GRAPHICAL SYMBOL RECOGNITION. WILEY ENCYCLOPEDIA OF ELECTRICAL AND ELECTRONICS ENGINEERING, 23 June 2015 (2015-06-23), XP055958062, Retrieved from the Internet <URL:https://hal.archives-ouvertes.fr/hal-01166512/document> [retrieved on 20220906], DOI: 10.1002/047134608X.W8260
- LEVENT BURAK KARA ET AL: "Hierarchical parsing and recognition of hand-sketched diagrams", ACM SIGGRAPH 2007 COURSES ON, SIGGRAPH '07, ACM PRESS, NEW YORK, NEW YORK, USA, 5 August 2007 (2007-08-05), pages 17 - es, XP058244684, ISBN: 978-1-4503-1823-5, DOI: 10.1145/1281500.1281528

## Beschreibung

Die Erfindung betrifft ein Verfahren zur Einbindung von zumindest einer, eine Datenschnittstelle aufweisende Überwachungs- und/oder Steuervorrichtung eines Überwachungs- und/oder Automatisierungssystems in eine Benutzerschnittstelle.

Des Weiteren betrifft die Erfindung eine Vorrichtung zur Steuerung zumindest einer Überwachungs- und/oder Steuervorrichtung eines Überwachungs- und/oder Automatisierungssystems, welche eine Datenschnittstelle aufweist.

Überwachungsvorrichtungen und/oder Steuervorrichtungen sind Bestandteile von Überwachungs- und/oder Automatisierungssystemen. Überwachungs- und/oder Automatisierungssysteme visualisieren und steuern Prozesse, welche beispielsweise in einer Industrieanlage oder in einem Gebäude durchgeführt werden und überwachen und beeinflussen verschiedene Prozessparameter. Überwachungsvorrichtungen können beispielsweise als Positionssensoren, Durchflussmesser, Temperatursensoren, Lichtsensoren, Druckmessgeräte, Manometer, Voltmeter, etc. ausgeführt sein. Steuervorrichtungen umfassen beispielsweise Stellmotoren, Antriebe, Ventilatoren, Kompressoren und Schalter. Weitere Beispiele für Überwachungsvorrichtungen und Steuervorrichtungen ergeben sind dem Fachmann allgemein bekannt. Beispielsweise auf dem Gebiet des Brandschutzes ist es üblich Gebäude mit einer Vielzahl an Überwachungsvorrichtungen und Steuervorrichtungen, zusammengefasst als Brandschutzvorrichtungen bezeichnet, auszustatten, welche dazu dienen einen möglichen Brand zu verhindern, zu detektieren und/oder einen ausgebrochenen Brand zu löschen, einzudämmen, und Evakuierungsmaßnahmen zu unterstützen. Überwachungsvorrichtungen und Steuervorrichtungen werden jedoch als Teil von Überwachungs- und/oder Automatisierungssystemen auf allen Gebieten der Gebäude-, Industrie- beziehungsweise Prozessüberwachung- und Automatisierung eingesetzt. Moderne Überwachungsvorrichtungen und Steuervorrichtungen weisen Datenschnittstellen auf, welche Betriebsinformation von Überwachungsvorrichtungen generieren und Steuerinformation zur Steuerung der Steuervorrichtungen verarbeiten. Die Betriebsinformation umfasst beispielsweise einen aktuellen Betriebsstatus der Überwachungsvorrichtung, wie die momentane Stellung einer Brandschutzklappe, die gemessene Temperatur eines Temperatursensors oder das Messsignal eines Rauchmelders. Eine solche Steuerinformation umfasst beispielsweise Information über eine erwünschte Stellung einer Brandschutzklappe, oder eine erwünschte Durchflussrate einer Pumpe. Die Datenschnittstellen sind mit einer zentralen Benutzerschnittstelle verbunden, welche es einem Benutzer erlaubt Betriebsinformation auszulesen und Steuerinformation einzugeben.

Benutzerschnittstellen gemäß dem aktuellen Stand der Technik umfassen eine interaktive, grafische Darstellung beispielsweise eines Plans des Überwachungs- und/oder Automatisierungssystems wie eine grafische Darstellung eines Prozessschemas, einen Anlagenplan, ein Anlagenschema, planmäßige Darstellungen von Wirkungen der Anlage, ein Überwachungsanlagenschema, oder einen Plan eines Gebäudes oder eines Gebäudeteils. In diesen Plänen sind die Positionen der einzelnen Überwachungsvorrichtungen und Steuervorrichtungen eingezeichnet. Hierdurch wird eine besonders benutzerfreundliche Darstellung der Betriebsinformation der Überwachungsvorrichtungen ermöglicht, da die von den Überwachungsvorrichtungen bereitgestellte Betriebsinformation von dem Benutzer direkt der jeweiligen Überwachungsvorrichtung in dem dargestellten Plan zugeordnet werden kann. Des Weiteren stellen derartige Benutzerschnittstellen eine besonders benutzerfreundliche Eingabemöglichkeit für Steuerinformation bereit, da die Steuerinformation für einzelne Steuervorrichtungen vom Benutzer direkt über den interaktiven Plan eingegeben werden kann.

Weniger fortschrittliche Benutzerschnittstellen herkömmlicher Überwachungs- und/oder Automatisierungssysteme umfassen einfache Anzeigeeinheiten, welche die Betriebsinformation einzelner Überwachungsvorrichtungen beispielsweise mittels verschiedenfarbiger LEDs und unter Angabe einer Datenschnittstellenbezeichnung der Datenschnittstelle der betreffenden Überwachungsvorrichtung ausgeben. Die Eingabe von Steuerinformation erfolgt unter Angabe beziehungsweise Auswahl der Datenschnittstellenbezeichnung der Datenschnittstelle der durch den Benutzer gewünschten Steuereinheit. Derartige Benutzerschnittstellen setzen voraus, dass der Benutzter Kenntnisse darüber verfügt, welche Datenschnittstellenbezeichnung der Datenschnittstelle welcher Überwachungsvorrichtung, beziehungsweise Steuervorrichtung zugeordnet ist. Derartige Systeme wurden in hoher Anzahl installiert und weisen eine wesentlich geringere Benutzerfreundlichkeit auf als Systeme mit Benutzerschnittstellen gemäß dem aktuellen Stand der Technik.

US 2016/091217 A1 offenbart ein Verfahren zur Steuerung von Umweltparametern in einem Gebäude, wie Beleuchtung, Temperatur und Luftfeuchtigkeit.

US 2009/307255 A1 offenbart ein Verfahren zur Verortung von Symbolen in einem Plan eines Gebäudes.

EP 3 156 856 A1 offenbart ein System zur Gebäudeautomatisierung mit physikalischen Trennelementen, welche eine Ebene des Gebäudes in verschiedene Zonen aufteilt.

Esquivel Esteban Arroyo: "Capturing and Exploiting Plant Topology and Process Information as a Basis to Support Engineering and Operational Activities in Process Plants", 9. Juni 2017, Internet:URL:https://opus.ub.hsu-hh.de/volltexte/2017/3162/pdf/PhDDissertation_Arroyo_Final.pdf offenbart ein Verfahren zum Erfassen und Ausnutzen von Anlagentopologie und Prozessinformationen als Grundlage zur Unterstützung von Engineering- und Betriebsaktivitäten in Prozessanlagen.

Es besteht somit ein Bedarf Überwachungsvorrichtungen und Steuervorrichtungen herkömmlicher Überwachungs- und/oder Automatisierungssysteme in eine interaktive, grafische Benutzerschnittstelle gemäß dem aktuellen Stand der Technik einzubinden. Der Erfindung liegt die Aufgabe zugrunde eine Lösung für diesen Bedarf bereitzustellen.

Erfindungsgemäß wird diese Aufgabenstellung durch ein Verfahren gemäß Anspruch 1.

Des Weiteren wird diese Aufgabenstellung durch eine Vorrichtung zur Steuerung von zumindest einer Überwachungs- und/oder Steuervorrichtung eines Überwachungs- und/oder Automatisierungssystems, welche eine Datenschnittstelle aufweist, gelöst, wobei die Vorrichtung eine Rechnereinheit mit einer Benutzerschnittstelle aufweist, und die Rechnereinheit mit der Datenschnittstelle verbunden, und dazu ausgebildet ist, das erfindungsgemäße Verfahren abzuarbeiten.

Zu herkömmlichen Überwachungs- und/oder Automatisierungssystemen sind in der Regel Pläne verfügbar, in welchen die Positionen von einzelnen Überwachungsvorrichtungen und Steuervorrichtungen des Systems gekennzeichnet sind. Überwachungsvorrichtungen und Steuervorrichtungen werden in diesen Plänen mit normierten Symbolen gekennzeichnet, wobei üblicherweise auch Datenschnittstellenbezeichnungen von zu den Überwachungs- und/oder Steuervorrichtungen zugehörigen Datenschnittstellen angeführt werden. Verschiedene Hersteller von Überwachungs- und/oder Automatisierungssystemen verwenden eine Vielzahl an unterschiedlichen und zum Teil proprietären Kennzeichnungsnormen, welche diese Symbole und die Benennung der Datenschnittstellenbezeichnungen festlegen.

Das erfindungsgemäße Verfahren vergleicht geometrische Strukturen, welche in dem Plan des Überwachungs- und/oder Automatisierungssystems enthalten sind, mit grafischen Symboldaten von Symbolen für Überwachungs- und/oder Steuervorrichtungen verschiedener Kennzeichnungsnormen, wobei ein Ausmaß an geometrischer Abweichung für die geometrischen Strukturen zu den grafischen Symboldaten bestimmt wird. Analog könnte auch ein Ausmaß an geometrischer Übereinstimmung ermittelt werden. Dieses Ausmaß wird herangezogen um eine erste Übereinstimmungswahrscheinlichkeit zu bestimmen und eine Zuordnungsprioritätenliste von den Symbolen zu den geometrischen Strukturen zu erstellen. Die Zuordnung der Symbole zu den geometrischen Strukturen erfolgt daraufhin entweder automatisiert mittels des Symbols mit der jeweils höchsten ersten Übereinstimmungswahrscheinlichkeit, oder manuell durch Benutzereingabe an der Benutzerschnittstelle, wobei der Benutzer durch die Zuordnungsprioritätenliste in der Zuordnung unterstützt wird. Hierdurch wird der Vorteil erreicht, dass auch bei Plänen mit geringer Qualität, wie beispielsweise eingescannten Plänen eine gute Treffsicherheit bei der Identifikation der einzelnen Symbole gewährleistet ist. Des Weiteren wird dem Benutzer ermöglicht die Zuordnung der Symbole manuell zu überprüfen oder zu korrigieren.

Nach der Zuordnung der Symbole zu den geometrischen Strukturen werden die jeweiligen Datenschnittstellen der durch die Symbole repräsentieren Überwachungs- und/oder Steuervorrichtungen zu den im letzten Schritt in dem Plan zugeordneten Symbolen zugeordnet, wobei dies anhand der Position des jeweiligen Symbols in dem Plan erfolgen kann. Hierdurch wird der Vorteil erreicht, dass der Benutzer durch die bereits zugeordneten Symbole nur noch Datenschnittstellen in Betracht ziehen muss, welche dem entsprechenden Symboltyp entsprechen. In der bevorzugten Ausführungsvariante des erfindungsgemäßen Verfahrens wird hierfür zusätzlich eine Erfassung von Datenschnittstellenbezeichnungen im Plan mittels Schrifterkennung bereitgestellt. In einem abschließenden Schritt wird eine Eingabeschnittstelle zur Eingabe von Steuerungsinformation an der Benutzerschnittstelle bereitgestellt. Hierbei kann der Benutzer durch Benutzerauswahl des Symbols, welches in dem Plan der Steuervorrichtung zugeordnet wurde, Steuerungsinformation eingeben und diese an die Datenschnittstelle der jeweiligen Steuervorrichtung übermitteln. Analog hierzu wird an der Benutzerschnittstelle eine Ausgabeschnittstelle bereitgestellt, an welcher von der Datenschnittstelle einer Überwachungsvorrichtung übermittelte Betriebsinformation ausgegeben wird. Die Betriebsinformation wird hierbei über das Symbol, welches der jeweiligen Überwachungsvorrichtung in dem Plan zugeordnet ist, ausgegeben. Hierdurch wird der Vorteil erreicht, dass durch das erfindungsgemäße Verfahren ein interaktiver Plan des Überwachungs- und/oder Automatisierungssystems erstellt wird, welcher als Benutzerschnittstelle fungiert um Steuerungsinformation einzugeben und Betriebsinformation auszugeben. Des Weiteren wird eine intuitive Bedienbarkeit und leicht verständliche Informationsausgabe für den Benutzer gewährleistet.

Vorteilhafte Ausgestaltungen des erfindungsgemäßen Verfahrens und der Vorrichtung sowie alternativer Ausführungsvarianten werden in weiterer Folge anhand der Figuren näher erläutert.
Figur 1 zeigt einen Plan eines Gebäudeteils in Grundrissdarstellung mit Symbolen für Überwachungsvorrichtungen und Steuervorrichtungen aus dem Gebiet des Brandschutzes, sowie Datenschnittstellenbezeichnungen.
Figur 2 zeigt eine Vorrichtung zur Steuerung von zumindest einer Überwachungs- und Steuervorrichtung mit einer Rechnereinheit, welche eine Benutzerschnittstelle aufweist.
Figur 3 zeigt die Vorrichtung zur Steuerung von zumindest einer Überwachungs- und Steuervorrichtung gemäß Figur 2 in einer alternativen Ausführungsvariante.

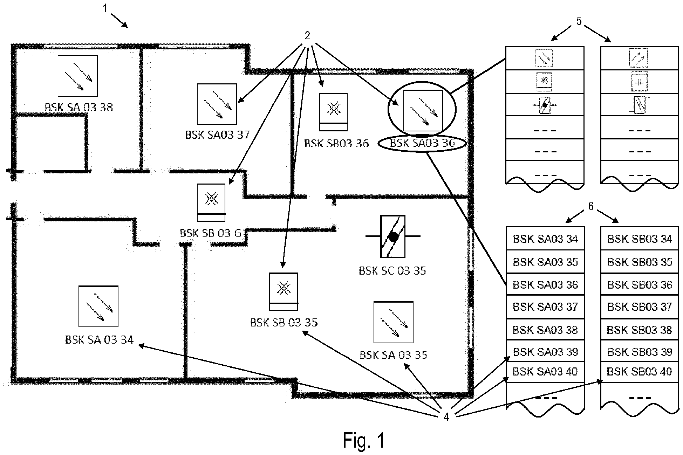

Figur 1 zeigt beispielhaft einen Plan 1 eines Gebäudeteils in Grundrissdarstellung mit geometrischen Strukturen, welche beispielsweise Wände, Türen und weitere Bauelemente des Gebäudes darstellen, sowie Symbole 2 für Überwachungsvorrichtungen und Steuervorrichtungen 3 aus dem Gebiet des Brandschutzes repräsentieren, welche in Figur 1 nicht dargestellt sind. Die in dem Plan 1 mittels der Symbole 2 eingezeichneten Überwachungsvorrichtungen und Steuervorrichtungen 3 umfassen fünf Rauchmelder, drei Temperatursensoren, sowie eine Brandschutzklappe und sind Teil eines Überwachungs- und/oder Automatisierungssystems auf dem Gebiet des Brandschutzes. Die, die Symbole 2 repräsentierenden, geometrischen Strukturen sind zudem mit Datenschnittstellenbezeichnungen 4 versehen. Neben dem Plan 1 sind in Figur 1 beispielhaft zwei Symbolverzeichnisse 5 dargestellt, welche grafische Symboldaten von Symbolen 2 von Überwachungs- und/oder Steuervorrichtungen 3 von zwei verschiedenen Kennzeichnungsnormen enthalten. Die grafischen Symboldaten sind hierbei jeweils durch eine Abbildung des durch diese definierten Symbols 2 dargestellt. Unterhalb der Symbolverzeichnisse 5 sind zwei Datenschnittstellenverzeichnisse 6 dargestellt, welche die Datenschnittstellenbezeichnungen 4 von Datenschnittstellen 7, welche in Figur 1 nicht dargestellt sind, der Überwachungs- und/oder Steuervorrichtungen 3 eines zugehörigen Überwachungs- und/oder Automatisierungssystems enthalten. Die Überwachungs- und/oder Steuervorrichtungen 3 weisen jeweils eine Datenschnittstelle 7 auf, welche jeweils eine Datenschnittstellenbezeichnung 4 tragen.

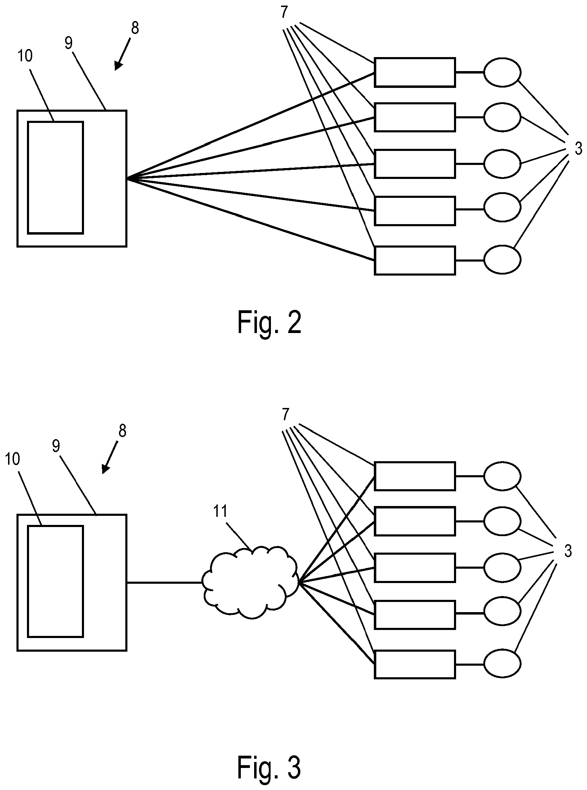

Figur 2 zeigt eine Vorrichtung 8 zur Steuerung von zumindest einer Überwachungs- und Steuervorrichtung 3 eines Überwachungs- und/oder Automatisierungssystems, wobei die dargestellte Vorrichtung 8 fünf Überwachungs- und/oder Steuervorrichtungen 3 steuert. Die Überwachungs- und/oder Steuervorrichtungen 3 sind jeweils mit einer Datenschnittstelle 7 verbunden. Die Vorrichtung 8 umfasst eine Rechnereinheit 9 mit einer Benutzerschnittstelle 10, wobei die Rechnereinheit 9 mit den Datenschnittstellen 7 verbunden ist.

In dem erfindungsgemäßen Verfahren zur Einbindung von zumindest einer, eine Datenschnittstelle 7 aufweisende Überwachungs- und/oder Steuervorrichtung 3 eines Überwachungs- und/oder Automatisierungssystems in die Benutzerschnittstelle 10 wird ein in einem Grafikdatenformat vorliegender Plan 1 des Überwachungs- und/oder Automatisierungssystems herangezogen. In Figur 1 ist beispielhaft ein Plan 1 dargestellt, welcher ein Gebäude beziehungsweise einen Gebäudeteil abbildet. In alternativen Ausführungsvarianten umfasst das erfindungsgemäße Verfahren den Verfahrensschritt des Bereitstellens des Plans 1 des Überwachungs- und/oder Automatisierungssystems in dem Grafikdatenformat, wobei der Plan 1 ein Gebäude oder einen Gebäudeteil, ein Prozessschema, ein Anlagenschema, einen Anlagenplan, einen Brandschutzplan, oder einen Überwachungsanlagenplan abbildet. Hierdurch wird der Vorteil erreicht, dass das erfindungsgemäße Verfahren auf Überwachungs- und/oder Automatisierungssysteme verschiedener Gebiete anwendbar ist. Die in dem Plan 1 des Überwachungs- und/oder Automatisierungssystems enthaltenen geometrischen Strukturen werden in einem weiteren Schritt mit den grafischen Symboldaten der Symbole 2 der Überwachungs- und/oder Steuervorrichtungen 3 verglichen, welche in Figur 1 beispielhaft mittels der beiden Symbolverzeichnisse 5 neben dem Plan 1 dargestellt sind. Die grafischen Symboldaten beinhalten Informationen über die geometrische Form der einzelnen Symbole 2 der unterschiedlichen Kennzeichnungsnormen, wodurch ein Vergleich mit den geometrischen Strukturen im Plan 1 ermöglicht wird. Der Vergleich erfolgt unter Anwendung von Bildverarbeitungstechniken, wie beispielsweise Kantenerkennung in einem in einem Pixclformat vorliegenden Plan 1, oder mittels Vcktorgrafikabglcich, wenn der Plan 1 in einem Vektorgrafikdatenformat vorliegt. Weitere Vergleichsmethoden ergeben sich für den Fachmann aus diesem beispielhaften Verweis. Im Zuge dieses Vergleichs wird ein Ausmaß an geometrischer Abweichung zwischen den geometrischen Strukturen in dem Plan 1 und den grafischen Symboldaten jedes der Symbole 2 bestimmt. In weiterer Folge werden anhand des bestimmten Ausmaßes an geometrischen Abweichungen erste Übereinstimmungswahrscheinlichkeiten zwischen den geometrischen Strukturen und den grafischen Symboldaten jedes der Symbole 2 bestimmt.

In einem weiteren Schritt wird eine, in Figur 1 nicht dargestellte, Zuordnungsprioritätenliste für die Symbole 2 zu den geometrischen Strukturen erstellt, welche nach den ersten Übereinstimmungswahrscheinlichkeiten geordnet ist. Anhand dieser Zuordnungsprioritätenliste kann im nächsten Verfahrensschritt eine automatisierte Zuordnung zumindest eines Symbols 2 zu zumindest einer geometrischen Struktur in dem Plan 1 erfolgen, indem das Symbol 2 mit der größten ersten Übereinstimmungswahrscheinlichkeit zu der entsprechenden geometrischen Struktur in dem Plan 1 zugeordnet wird. Alternativ kann die Zuordnung erfolgen, indem die Zuordnungsprioritätenliste über die Benutzerschnittstelle 10 ausgegeben wird, und eine Benutzereingabe zum Zuordnen zumindest eines der Symbole 2 zu zumindest einer geometrischen Struktur in dem Plan 1 abgefragt wird. Diese Zuordnung ist in Figur 1 am Beispiel des Rauchmelders mit der Datenschnittstellenbezeichnung 4 "BSK SA03 36" symbolisch dargestellt. Der Benutzer wird für eine manuelle Zuordnung durch die Zuordnungsprioritätenliste unterstützt, da die Zuordnungsprioritätenliste die wahrscheinlichsten Zuordnungen der Symbole 2 zu den geometrischen Strukturen in dem Plan 1 des Überwachungs- und/oder Automatisierungssystems enthält.

Nach erfolgter Zuordnung des beziehungsweise der Symbole 2 zu der zumindest einen geometrischen Struktur in dem Plan 1 wird den zugeordneten Symbolen 2 jeweils die Datenschnittstelle 7 des an der Position des Symbols 2 im Plan 1 installierten Überwachungs- und/oder Steuervorrichtung 3 zugeordnet. Hierdurch wird eine Verbindung zwischen den in dem Plan 1 identifizierten und zugeordneten Symbolen 2 und der Datenschnittstelle 7 der jeweiligen Überwachungs- beziehungsweise Steuervorrichtung 3 erreicht. Die Zuordnung erfolgt in dieser Ausführungsvariante des erfindungsgemäßen Verfahrens anhand der Position der Symbole 2 in dem Plan 1 und der Position der Überwachungs- beziehungsweise Steuervorrichtungen 3 in dem Überwachungs- und/oder Automatisierungssystem. In dem in Figur 1 beispielhaft dargestellten Plans 1 eines Gebäudeteils kann der Benutzer für die Zuordnung die Datenschnittstellen 7 beispielsweise manuell und optisch vor Ort in dem Gebäude identifizieren und die entsprechenden Datenschnittstellenbezeichnungen 4 den Symbolen 2 zuordnen: Dies ist in Figur 1 mit der Datenschnittstellenbezeichnung 4 "BSK SA03 36" symbolisch dargestellt. Bildet der Plan 1 beispielsweise ein Anlagenschema ab kann der Benutzer anhand der Position des Symbols in dem Plan 1 die Position der Überwachungs- und/oder Steuervorrichtung in der Anlage bestimmen und somit die Datenschnittstellenbezeichnung in Erfahrung bringen. Dieses Prinzip kann beispielsweise auch für Brandschutzpläne, Überwachungsanlagenpläne oder Prozessschemata angewendet werden.

Das erfindungsgemäße Verfahren sieht zudem vor, eine Eingabeschnittstelle zur Eingabe von Steuerungsinformation durch den Benutzer durch Benutzerauswahl des in dem Plan 1des Überwachungs- und/oder Automatisierungssystems der Steuervorrichtung 3 zugeordneten Symbols 2 und Übermittlung der durch den Benutzer eingegebenen Steuerungsinformation an die Datenschnittstelle 7 der Steuervorrichtung 3 an der Benutzerschnittstelle 10 bereitzustellen. Des Weiteren sieht das erfindungsgemäße Verfahren vor, von der Datenschnittstelle 7 der Überwachungsvorrichtung 3 bereitgestellte, Betriebsinformation an den Benutzer an der Benutzerschnittstelle 10 durch in dem Plan 1 des Überwachungs- und/oder Automatisierungssystems der Überwachungsvorrichtung 3 zugeordnete Symbol 2 zugeordnetes Anzeigen der Betriebsinformation bereitzustellen. Hierdurch wird der Vorteil erreicht, dass die Benutzerschnittstelle 10 eine interaktive Eingabemöglichkeit bereitstellt, wodurch Steuerinformationen direkt über eine Benutzerauswahl des jeweiligen Symbols 2 der betreffenden Steuervorrichtung 3 in dem Plan 1 an der Benutzerschnittstelle 10 eingegeben werden kann, und Betriebsinformation durch Auswahl des entsprechenden Symbols 2 der jeweiligen Überwachungsvorrichtung 3 in dem Plan 1 an der Benutzerschnittstelle 10 ausgegeben werden kann. Besonders vorteilhaft ist hierbei, dass das erfindungsgemäße Verfahren die Möglichkeit bereitstellt, herkömmliche Überwachungs- und/oder Automatisierungssysteme mit einer interaktiven, grafischen Benutzerschnittstelle 10 zu versehen.

Die beiden Symbolverzeichnisse 5 und die beiden Datenschnittstellenverzeichnisse 6 sind in Figur 1 nur beispielhaft angeführt. Das erfindungsgemäße Verfahren kann je nach konkretem Anwendungsfall auf eine unbestimmte Anzahl an Symbolverzeichnissen 5 und Datenschnittstellenverzeichnissen 6 zurückgreifen.

Gemäß der bevorzugten Ausführungsvariante des erfindungsgemäßen Verfahrens werden die den geometrischen Strukturen in dem Plan 1 zugeordneten Datenschnittstellenbezeichnungen 4 mittels Schrifterkennung erfasst. Die durch Schrifterkennung erfassten Datenschnittstellenbezeichnungen 4 werden daraufhin mit der Datenschnittstellenbezeichnung 4 der Datenschnittstelle 7 der zumindest einen Überwachungs- und Steuervorrichtung 3 verglichen. In Bezug auf den in Figur 1 beispielhaft dargestellten Plan 1, werden die in dem Plan 1 mittels Schrifterkennung erfassten Datenschnittstellenbezeichnungen 4 mit den Einträgen der beiden Datenschnittstellenverzeichnisse 6 verglichen. In einem weiteren Schritt wird eine zweite Übereinstimmungswahrscheinlichkeit zwischen den erfassten Datenschnittstellenbezeichnungen 4 und der Datenschnittstellenbezeichnung 4 der Datenschnittstelle 7 der zumindest einen Überwachungs- und Steuervorrichtung 7 bestimmt. Die Bestimmung der zweiten Übereinstimmungswahrscheinlichkeit basiert darauf, dass die Datenschnittstellenbezeichnungen 4 in dem Plan 1, beispielsweise aufgrund von Bildqualitätsmängeln des Plans 1, ungewöhnlicher Schriftarten, etc., nicht immer fehlerfrei erkannt werden. Es können beispielsweise Abweichungen in einem erfassten Buchstaben oder einer erfassten Ziffer der Datenschnittstellenbezeichnung 4 auftreten. Die fehlerhaft erfasste Datenschnittstellenbezeichnung 4 entspricht infolgedessen nicht genau einer Datenschnittstellenbezeichnung 4 in einem der beiden Datenschnittstellenverzeichnisse 6, weist jedoch eine hohe zweite Übereinstimmungswahrscheinlichkeit mit dem korrekten Eintrag auf. Daraufhin wird die Datenschnittstelle 7 mit der Datenschnittstellenbezeichnung 4 mit der größten zweiten Übereinstimmungswahrscheinlichkeit zu dem der geometrischen Struktur zugeordneten Symbol 2 zugeordnet. Hierdurch wird der Vorteil erreicht, dass eine automatisierte Zuordnung von den zugeordneten Symbolen 2 zu den Datenschnittstellen 7 bereitgestellt wird. Alternativ wird eine Benutzereingabe zum Zuordnen des einer geometrischen Struktur zugeordneten, Symboles 2 zu der Datenschnittstelle 7 abgefragt. Hierbei wird zumindest eines von der durch Schrifterkennung erfassten Datenschnittstellenbezeichnung 4, der Datenschnittstellenbezeichnung 4 der Datenschnittstelle 7, der ersten Übereinstimmungswahrscheinlichkeit und der zweiten Übereinstimmungswahrscheinlichkeit ausgegeben. Hierdurch wird der Vorteil erreicht, dass der Benutzer die Zuordnung an der Benutzerschnittstelle 10 manuell treffen kann, jedoch nicht darauf angewiesen ist die Datenschnittstellenbezeichnungen 4 der Datenschnittstellen 7 in dem Gebäude manuell in Erfahrung zu bringen.

Gemäß einer Ausführungsvariante des erfindungsgemäßen Verfahrens ist die Benutzerschnittstelle 10 an einer mit einem in Figur 3 dargestellten Netzwerk 11 verbundenen Rechnereinheit 9 bereitgestellt. Die Steuerungsinformation wird in dieser Ausführungsvariante von der Rechnereinheit 9 über das Netzwerk 11 an die Datenschnittstelle 7 übermittelt, und die Betriebsinformation wird von der Datenschnittstelle 7 über das Netzwerk 11 an die Rechnereinheit 9 übermittelt. Hierdurch wird der Vorteil erreicht, dass die Benutzerschnittstelle an einer Rechnereinheit 9 bereitgestellt werden kann, welche sich nicht am Ort des Überwachungs- und/oder Automatisierungssystems selbst befindet. Die Rechnereinheit 9 kann beispielsweise ein Smartphone, einen Tabletcomputer einen Laptop darstellen, welche einen Internetanschluss, wobei das Internet in diesem Beispiels das Netzwerk 11 darstellt, aufweisen. Besonders vorteilhaft ist, dass hierdurch die Möglichkeit bereitgestellt wird, ortsunabhängig auf die Überwachungs- und/oder Steuervorrichtungen 3 des Überwachungs- und/oder Automatisierungssystems zuzugreifen. Des Weiteren können hierdurch von einer Rechnereinheit 9 auf die Überwachungs- und/oder Steuervorrichtungen 3 verschiedener Überwachungs- und/oder Automatisierungssysteme zugegriffen werden.

In der bevorzugten Ausführungsvariante des erfindungsgemäßen Verfahrens wird zudem eine Liste der den geometrischen Strukturen in dem Plan 1 zugeordneten Symbole 2 sowie der den zugeordneten Symbolen 2 zugeordneten Datenschnittstellen 7 erstellt. Die Liste und der Plan 1 werden zudem in einer gemeinsamen Datei gespeichert. Hierdurch wird der Vorteil erreicht, dass die im Zuge des Verfahrens getroffenen Zuordnungen jederzeit einsehbar und bei Änderungen an den Überwachungs- und/oder Steuervorrichtungen 3 jederzeit modifizierbar sind.

Im Rahmen der Erfindung wird zudem die Vorrichtung 8 zur Steuerung von zumindest einer Überwachungs- und/oder Steuervorrichtung 3 eines Überwachungs- und/oder Automatisierungssystems, welche eine Datenschnittstelle 7 aufweist, bereitgestellt, welche in Figur 2 dargestellt ist. Die Vorrichtung weist eine Rechnereinheit 9 mit einer Benutzerschnittstelle 10 auf. Die Rechnereinheit 9 ist mit der Datenschnittstelle 7 verbunden und arbeitet das hierin beschriebene Verfahren ab.

Figur 3 zeigt die Vorrichtung 8 gemäß Figur 2 in einer bevorzugten Ausführungsvariante, wobei die Rechnereinheit 9 mit dem Netzwerk 11 verbunden ist. Die Datenschnittstellen 7 sind ebenfalls mit dem Netzwerk 11 verbunden. Hierdurch wird der Vorteil erreicht, dass die Benutzerschnittstelle 10 an einer Rechnereinheit 9 bereitgestellt werden kann, welche sich nicht am Ort des Überwachungs- und/oder Automatisierungssystems befindet. Die Rechnereinheit 9 kann beispielsweise ein Smartphone, einen Tabletcomputer einen Laptop darstellen, welche einen Internetanschluss aufweisen. Besonders vorteilhaft ist, dass hierdurch die Möglichkeit bereitgestellt wird, ortsunabhängig auf die Überwachungs- und/oder Steuervorrichtungen 3 des Überwachungs- und/oder Automatisierungssystems zuzugreifen. Des Weiteren können hierdurch von einer Rechnereinheit 9 auf die Überwachungs- und/oder Steuervorrichtungen 3 verschiedener Überwachungs- und/oder Automatisierungssysteme zugegriffen werden.

Die Verwendung des erfindungsgemäßen Verfahrens und der erfindungsgemäßen Vorrichtung sind insbesondere bei Überwachungs- und/oder Automatisierungssystemen in der Form von Brandschutzanlagen, welche in großen Gebäuden wie Hochhäusern von 20 und mehr Stockwerken installiert sind, oder großen Industrieanlagen, wie Produktionsanlage, Produktionsstraßen, etc. oder Überwachungsanlagen von Vorteil. Hierdurch ist eine zügige Einbindung aller Überwachungs- und/oder Steuervorrichtungen des Überwachungs- und/oder Automatisierungssystems in eine interaktive grafische Benutzerschnittstelle zur Ausgabe von Betriebsinformation und zur Eingabe der Steuerungsinformation ermöglicht. Im Zuge dieser Einbindung können gegebenenfalls mehrere hundert oder gar tausend Überwachungs- und/oder Steuervorrichtungen zuverlässig und innerhalb kurzer Zeit in die grafische Benutzerschnittstelle eingebunden werden. Hierdurch wird das technische Problem einer zuverlässigen und fehlerfreien Steuerung von Steuereinrichtungen des Überwachungs- und/oder Automatisierungssystems gelöst.

## Patentansprüche

1. Verfahren zur Einbindung von zumindest einer, eine Datenschnittstelle (7) aufweisende Überwachungs- und/oder Steuervorrichtung (3) eines Überwachungs- und/oder Automatisierungssystems in eine Benutzerschnittstelle (10), umfassend die Schritte:
a) Vergleichen von geometrischen Strukturen mit grafischen Symboldaten von Symbolen (2) von Überwachungs- und/oder Steuervorrichtungen (3), wobei die geometrischen Strukturen in einem Plan (1) des Überwachungs- und/oder Automatisierungssystems enthalten sind, wobei der Plan (1) in einem Grafikdatenformat vorliegt und wobei die grafischen Symboldaten Informationen über die geometrische Form der Symbole (2) enthalten;
b) Bestimmen eines Ausmaßes an geometrischer Abweichung zwischen den geometrischen Strukturen und den grafischen Symboldaten jedes der Symbole (2);
c) Bestimmen von ersten Übereinstimmungswahrscheinlichkeiten zwischen den geometrischen Strukturen und den grafischen Symboldaten jedes der Symbole (2) anhand des Ausmaßes an geometrischen Abweichungen;
d) Erstellen einer Zuordnungsprioritätenliste für die Symbole (2) zu den geometrischen Strukturen geordnet nach den ersten Übereinstimmungswahrscheinlichkeiten;
e) Zuordnen des Symbols (2) aus der Zuordnungsprioritätenliste mit der größten ersten Übereinstimmungswahrscheinlichkeit zu der entsprechenden geometrischen Struktur in dem Plan (1) oder
Ausgabe der Zuordnungsprioritätenliste über die Benutzerschnittstelle (10) und Abfragen einer Benutzereingabe zum Zuordnen zumindest eines der Symbole (2) zu zumindest einer geometrischen Struktur in dem Plan (1);
f) Zuordnen der Datenschnittstelle (7) der an der Position des Symbols im Plan (1) installierten Überwachungs- und/oder Steuervorrichtung (3) zu dem, der geometrischen Struktur zugeordneten, Symbol (2);
g) Bereitstellen einer Eingabeschnittstelle zur Eingabe von Steuerungsinformation durch den Benutzer an der Benutzerschnittstelle (10) durch Benutzerauswahl des in dem Plan (1) des Überwachungs- und/oder Automatisierungssystems der Steuervorrichtung (3) zugeordneten Symbols (2) und Übermittlung der durch den Benutzer eingegebenen Steuerungsinformation an die Datenschnittstelle (7) der Steuervorrichtung (3) und/oder Bereitstellen einer Ausgabeschnittstelle zur Ausgabe von, von der Datenschnittstelle (7) der Überwachungsvorrichtung (3) bereitgestellter, Betriebsinformation an den Benutzer an der Benutzerschnittstelle (10) durch in dem Plan (1) des Überwachungs- und/oder Automatisierungssystems der Überwachungsvorrichtung (3) zugeordnete Symbol (2) zugeordnetes Anzeigen der Betriebsinformation;
h) Ausführen des Schritts f) durch Erfassen von den geometrischen Strukturen in dem Plan (1) zugeordneten Datenschnittstellenbezeichnungen (4) mittels Schrifterkennung und Vergleichen der durch Schrifterkennung erfassten Datenschnittstellenbezeichnungen (4) mit einer Datenschnittstellenbezeichnung (4) der Datenschnittstelle (7) der zumindest einen Überwachungs- und Steuervorrichtung (3); und
i) Bestimmen einer zweiten Übereinstimmungswahrscheinlichkeit zwischen den erfassten Datenschnittstellenbezeichnungen (4) und der Datenschnittstellenbezeichnung (4) der Datenschnittstelle (7) der zumindest einen Überwachungs- und Steuervorrichtung (3); und
j) Zuordnen der Datenschnittstelle (7) mit der Datenschnittstellenbezeichnung (4) mit der größten zweiten Übereinstimmungswahrscheinlichkeit zu dem der geometrischen Struktur zugeordneten Symbol (2) oder
Abfragen einer Benutzereingabe zum Zuordnen des einer geometrischen Struktur zugeordneten, Symboles (2) zu der Datenschnittstelle (7) durch Ausgabe von zumindest eines von der durch Schrifterkennung erfassten Datenschnittstellenbezeichnung (4), der Datenschnittstellenbezeichnung (4) der Datenschnittstelle (7), der ersten Übereinstimmungswahrscheinlichkeit und der zweiten Übereinstimmungswahrscheinlichkeit.

2. Verfahren gemäß Anspruch 1, umfassend die Schritte:
k) Bereitstellen der Benutzerschnittstelle (10) an einer mit einem Netzwerk (11) verbundenen Rechnereinheit (9); und
l) Übermitteln von Steuerungsinformation von der Rechnereinheit (9) über das Netzwerk (11) an die Datenschnittstelle (7); und
m) Übermitteln von Betriebsinformation von der Datenschnittstelle (7) über das Netzwerk (11) an die Rechnereinheit (9).

3. Verfahren gemäß einem der Ansprüche 1 oder 2, umfassend die Schritte:
n) Erstellen einer Liste der den geometrischen Strukturen in dem Plan (1)zugeordneten Symbole (2) sowie der den zugeordneten Symbolen (2) zugeordneten Datenschnittstellen (7); und
o) Speichern der Liste und des Plans (1) in einer gemeinsamen Datei.

4. Verfahren gemäß einem der Ansprüche 1 bis 3, umfassend den Schritt:
p) Bereitstellen des Plans (1) des Überwachungs- und/oder Automatisierungssystems in dem Grafikdatenformat vor dem Schritt a), wobei der Plan (1) ein Gebäude oder einen Gebäudeteil abbildet.

5. Verfahren gemäß einem der Ansprüche 1 bis 3, umfassend den Schritt:
p) Bereitstellen des Plans (1) des Überwachungs- und/oder Automatisierungssystems in dem Grafikdatenformat vor dem Schritt a), wobei der Plan (1) ein Prozessschema abbildet.

6. Verfahren gemäß einem der Ansprüche 1 bis 3, umfassend den Schritt:
p) Bereitstellen des Plans (1) des Überwachungs- und/oder Automatisierungssystems in dem Grafikdatenformat vor dem Schritt a), wobei der Plan (1) ein Anlagenschema oder einen Anlagenplan abbildet.

7. Verfahren gemäß einem der Ansprüche 1 bis 3, umfassend den Schritt:
p) Bereitstellen des Plans (1) des Überwachungs- und/oder Automatisierungssystems in dem Grafikdatenformat vor dem Schritt a), wobei der Plan (1) einen Brandschutzplan abbildet.

8. Verfahren gemäß einem der Ansprüche 1 bis 3, umfassend den Schritt:
p) Bereitstellen des Plans (1) des Überwachungs- und/oder Automatisierungssystems in dem Grafikdatenformat vor dem Schritt a), wobei der Plan (1) einen Überwachungsanlagenplan abbildet.

9. Vorrichtung (8) zur Steuerung von zumindest einer Überwachungs- und/oder Steuervorrichtung (3) eines Überwachungs- und/oder Automatisierungssystems, welche eine Datenschnittstelle (7) aufweist, wobei die Vorrichtung (8) eine Rechnereinheit (9) mit einer Benutzerschnittstelle (10) aufweist, und die Rechnereinheit (9) mit der Datenschnittstelle (7) verbunden, und dazu ausgebildet ist, ein Verfahren gemäß einem der Ansprüche 1 bis 8 abzuarbeiten.

## Claims

1. Method for integrating at least one monitoring and/or control device (3) of a monitoring and/or automation system having a data interface (7) into a user interface (10), comprising the following steps:
a) comparison of geometric structures with graphic symbol data of symbols (2) of monitoring and/or control devices (3), wherein the geometric structures are contained in a plan (1) of the monitoring and/or automation system, wherein the plan (1) is in a graphic data format and wherein the graphic symbol data contain information about the geometric shape of the symbols (2);
b) determine an amount of geometric deviation between the geometric structures and the graphical symbol data of each of the symbols (2);
c) determine initial probabilities of correspondence between the geometric structures and the graphical symbol data of each of the symbols (2) based on the extent of geometric deviations;
d) create an assignment priority list for the symbols (2) to the geometric structures ordered according to the first match probabilities;
e) assigning the symbol (2) from the assignment priority list with the highest first match probability to the corresponding geometric structure in the plan (1) or
Outputting the assignment priority list via the user interface (10) and requesting a user input for assigning at least one of the symbols (2) to at least one geometric structure in the plan (1);
f) assigning the data interface (7) of the monitoring and/or control device (3) installed at the position of the symbol in the plan (1) to the symbol (2) assigned to the geometric structure;
g) providing an input interface for the input of control information by the user at the user interface (10) by user selection of the symbol (2) assigned in the plan (1) of the monitoring and/or automation system of the control device (3) and transmission of the control information entered by the user to the data interface (7) of the control device (3) and/or provision of an output interface for outputting operating information provided by the data interface (7) of the monitoring device (3) to the user at the user interface (10) by displaying the operating information assigned to the monitoring device (3) in the plan (1) of the monitoring and/or automation system by means of the assigned symbol (2);
h) carrying out step f) by detecting data interface designations (4) assigned to the geometric structures in the plan (1) by means of character recognition and comparing the data interface designations (4) detected by character recognition with a data interface designation (4) of the data interface (7) of the at least one monitoring and control device (3); and
i) determining a second match probability between the detected data interface identifiers (4) and the data interface identifier (4) of the data interface (7) of the at least one monitoring and control device (3); and
j) assigning the data interface (7) with the data interface designation (4) with the greatest second match probability to the symbol (2) assigned to the geometric structure, or interrogation of a user input for assigning the symbol (2) assigned to a geometric structure to the data interface (7) by outputting at least one of the data interface designation (4) detected by character recognition, the data interface designation (4) of the data interface (7), the first match probability and the second match probability.

2. Method according to claim 1, comprising the steps of:
k) providing the user interface (10) at a computer unit (9) connected to a network (11); and
l) transmitting control information from the computer unit (9) via the network (11) to the data interface (7); and
m) transmitting operating information from the data interface (7) via the network (11) to the computer unit (9).

3. Method according to any of claims 1 or 2, comprising the steps of:
n) creating a list of the symbols (2) associated with the geometric structures in the plan (1) and the data interfaces (7) associated with the associated symbols (2); and
o) saving the list and the plan (1) in a common file.

4. Method according to any one of claims 1 to 3, comprising the step of:
p) providing the plan (1) of the monitoring and/or automation system in the graphics data format prior to step a), wherein the plan (1) depicts a building or a part of a building.

5. Method according to any one of claims 1 to 3, comprising the step of:
p) providing the plan (1) of the monitoring and/or automation system in the graphic data format prior to step a), wherein the plan (1) depicts a process schematic.

6. Method according to any one of claims 1 to 3, comprising the step of:
p) providing the plan (1) of the monitoring and/or automation system in the graphic data format prior to step a), wherein the plan (1) depicts a plant schematic or a plant plan.

7. Method according to any one of claims 1 to 3, comprising the step of:
p) providing the plan (1) of the monitoring and/or automation system in the graphic data format prior to step a), wherein the plan (1) depicts a fire protection plan.

8. Method according to any one of claims 1 to 3, comprising the step of:
p) providing the plan (1) of the monitoring and/or automation system in the graphic data format prior to step a), wherein the plan (1) depicts a monitoring system plan.

9. Device (8) for controlling at least one monitoring and/or control device (3) of a monitoring and/or automation system, which has a data interface (7), wherein the device (8) has a computer unit (9) with a user interface (10), and the computer unit (9) is connected to the data interface (7) and is designed to process a method according to one of claims 1 to 8.

## Revendications

1. Procédé pour intégrer au moins un dispositif de surveillance et/ou de commande (3) comportant une interface de données (7) d'un système de surveillance et/ou d'automatisation dans une interface utilisateur (10), comprenant les étapes suivantes :
a) comparaison de structures géométriques avec des données de symbole graphique de symboles (2) de dispositifs de surveillance et/ou d'automatisation (3), lesquelles structures géométriques sont contenues dans un plan (1) du système de surveillance et/ou d'automatisation, lequel plan (1) se trouve dans un format de données graphiques et lesquelles données de symbole graphique contiennent des informations sur la forme géométrique des symboles (2),
b) détermination d'un degré d'écart géométrique entre les structures géométriques et les données de symbole graphique de chacun des symboles (2),
c) détermination de premières probabilités de correspondance entre les structures géométriques et les données de symbole graphique de chacun des symboles (2) à l'aide du degré d'écart géométrique,
d) création d'une liste de priorité d'affectation des symboles (2) aux structures géométriques classées selon les premières probabilités de correspondance,
e) assignation du symbole (2) de la liste de priorité d'affectation ayant la plus grande première probabilité de correspondance à la structure géométrique correspondante dans le plan (1) ou
sortie de la liste de priorité d'affectation via l'interface utilisateur (10) et demande d'une entrée utilisateur pour assigner au moins un des symboles (2) à au moins une structure géométrique dans le plan (1),
f) assignation de l'interface de données (7) du dispositif de surveillance et/ou de commande (3) installé à l'emplacement du symbole dans le plan (1) au symbole (2) assigné à la structure géométrique,
g) fourniture d'un interface d'entrée pour l'entrée de commandes par l'utilisateur au niveau de l'interface utilisateur (10) par la sélection par l'utilisateur du symbole (2) assigné dans le plan (1) du système de surveillance et/ou d'automatisation du système de commande (3) et la transmission de l'information de commande entrée par l'utilisateur à l'interface de données (7) du dispositif de commande (3) et/ou fourniture d'une interface de sortie pour la sortie de l'information de fonctionnement fournie par l'interface de données (7) du dispositif de surveillance (3) à l'utilisateur au niveau de l'interface utilisateur (10) par l'affichage de l'information de fonctionnement associé avec le symbole (2) associé dans le plan (1) du système de surveillance et/ou d'automatisation du dispositif de surveillance (3),
h) Exécution de l'étape f) par le biais de l'acquisition de désignations d'interface de données (4) assignées aux structures géométriques dans le plan (1) au moyen de la reconnaissance des caractères et de la comparaison des désignations d'interface de données (4) acquises par la reconnaissance des caractères avec une désignation d'interface de données (4) de l'interface de données (7) de l'au moins un dispositif de surveillance et de commande (3),
i) détermination d'une deuxième probabilité de correspondance entre les désignations d'interface de données (4) enregistrées et la désignation d'interface de données (4) de l'interface de données (7) de l'au moins un dispositif de surveillance et de commande (3), et
j) assignation de l'interface de données (7) ayant la désignation d'interface de données (4) dotée de la plus grande deuxième probabilité de correspondance au symbole (2) assigné à la structure géométrique ou
demande d'une entrée utilisateur pour l'assignation du symbole (2) assigné à une structure géométrique à l'interface de données (7) par la sortie d'au moins la désignation d'interface de données (4) détectée par la reconnaissance des caractères, la désignation d'interface de données (4) de l'interface de données (7), la première probabilité de correspondance et/ou la deuxième probabilité de correspondance.

2. Procédé selon la revendication 1, comprenant les étapes suivantes :
k) fourniture de l'interface utilisateur (10) à une unité informatique (9) connectée à un réseau (11),
l) transmission d'informations de commande de l'unité informatique (9) à l'interface de données (7) via le réseau (11) et
m) transmission d'informations de fonctionnement de l'interface de données (7) à l'unité informatique (1) via le réseau (11).

3. Procédé selon la une des revendications 1 ou 2, comprenant les étapes suivantes :
n) création d'une liste des symboles (2) assignés au structures géométriques dans le plan (1) et des interfaces de données (7) assignées aux symboles (2) assignés et
o) enregistrement de la liste et du plan (1) dans un fichier commun.

4. Procédé selon la une des revendications 1 à 3, comprenant l'étape suivante :
p) fourniture du plan (1) du système de surveillance et/ou d'automatisation dans le format de données graphiques avant l'étape a), le plan (1) représentant un bâtiment ou une partie de bâtiment.

5. Procédé selon la une des revendications 1 à 3, comprenant l'étape suivante :
p) fourniture du plan (1) du système de surveillance et/ou d'automatisation dans le format de données graphiques avant l'étape a), le plan (1) représentant un schéma de processus.

6. Procédé selon la une des revendications 1 à 3, comprenant l'étape suivante :
p) fourniture du plan (1) du système de surveillance et/ou d'automatisation dans le format de données graphiques avant l'étape a), le plan (1) représentant un schéma d'installation ou un plan d'installation.

7. Procédé selon la une des revendications 1 à 3, comprenant l'étape suivante :
p) fourniture du plan (1) du système de surveillance et/ou d'automatisation dans le format de données graphiques avant l'étape a), le plan (1) représentant un plan de protection anti-incendie.

8. Procédé selon la une des revendications 1 à 3, comprenant l'étape suivante :
p) fourniture du plan (1) du système de surveillance et/ou d'automatisation dans le format de données graphiques avant l'étape a), le plan (1) représentant un plan d'installation de surveillance.

9. Dispositif (8) pour le contrôle d'au moins un dispositif de surveillance et/ou de commande (3) d'un système de surveillance et d'automatisation qui comporte une interface de données (7), lequel dispositif (8) comporte une unité informatique (9) avec une interface utilisateur (10), l'unité informatique (9) étant reliée avec l'interface utilisateur (10) et conçue pour mettre en oeuvre un procédé selon une des revendications 1 à 8.
